# EUROPÄISCHE PATENTSCHRIFT

(11) **EP 0 269 997 B1**
(45) Veröffentlichungstag und Bekanntmachung des Hinweises auf die Patenterteilung: **06.04.1994**
(21) Anmeldenummer: 87117434.8
(22) Anmeldetag: 26.11.1987
(51) Int. Cl.: B28D 5/02, B23D 59/02

(54) **Verfahren und Vorrichtung zur Korrektur des Schnittverlaufs beim Zersägen von Kristallstäben oder -blöcken.**
Process and device for the correction of the cutting direction for sawing crystal rods or blocks
Procédé et dispositif de correction de la direction de coupe pour scier des tiges ou blocs de cristal

(30) Priorität: 28.11.1986 DE 3640645
(43) Veröffentlichungstag der Anmeldung: 08.06.1988
(73) Patentinhaber: Wacker-Chemitronic Gesellschaft für Elektronik-Grundstoffe mbH, D-84489 Burghausen (DE)
(72) Erfinder: Brehm, Gerhard, Dr. Dipl.-Ing., D-8261 Emmerting (DE); Langsdorf, Karlheinz, Dipl.-Ing., D-8263 Burghausen (DE); Niedermeier, Johann, D-8261 Burgkirchen (DE); Glas, Johann, D-8263 Burghausen (DE)

(56) Entgegenhaltungen:
- EP-A- 0 093 406
- DE-B- 1 208 979
- FR-A- 2 412 385
- US-A- 2 475 811
- US-A- 2 991 599
- US-A- 4 136 590
- IBM TECHNICAL DISCLOSURE BULLETIN, Band 16, Nr. 8, Januar 1974, Seite 2550, NewYork, US; E. MENDEL: "Substrate slicing - coolant feed system"
- IBM TECHNICAL DISCLOSURE BULLETIN, Band 25, Nr. 5, Oktober 1982, Seiten 2283-2284, New York, US; P.R. CARUFE et al.: "System for controlling saw bladeexcursions during the slicing of silicon crystals"
- PATENT ABSTRACTS OF JAPAN, Band 11, Nr. 1 (M-035), 8. September 1977, Seite2997 M 77

## Beschreibung

Die Erfindung betrifft ein Verfahren zur Korrektur der Abweichung eines Sägeblattes von der gewünschten Schnittlinie beim Zersägen von Kristallstäben oder -blöcken in dünne Scheiben vermittels Innenlochsäge, wobei während des Sägevorganges ein flüssiges Kühlschmiermittel auf die Schneidkante des Sägeblattes aufgebracht wird und zusätzlich eine Flüssigkeit außerhalb des Sägespaltes auf eine oder beide Seitenflächen des rotierenden Sägeblattes aufgebracht und durch die Rotation des Sägeblattes zumindest teilweise in den Sägespalt transportiert wird.

Ferner betrifft die Erfindung auch eine Vorrichtung zur Durchführung des beanspruchten Verfahrens.

Für das Zersägen von Kristallstäben oder -blöcken, insbesondere aus Halbleitermaterialien wie z.B. Silicium, Germanium, Galliumarsenid oder Indiumphosphid, aber auch aus oxidischen Materialien wie Gallium-Gadolinium-Granat, Saphir, Spinell, Quarz oder Glas in dünne Schieben von typisch etwa 0,1 - 2 mm, wie sie beispeilsweise bei der Herstellung elektronishcher Bauelemente oder von Solarzellen Verwendung finden, werden hauptsächlich Innenlochsägen eingesetzt. Bei diesen wird der Sägevorgang durch ein an seinem Außenumfang in einen Spannrahmen eingespanntes, kreisrundes rotierendes Sägeblatt ausgeführt, dessen mit einem harten Schleifbelag, z.B. aus in der Regel in eine Nickelschicht eingebetteten Diamant- oder Bornitridkörnern versehener Innenrand die eigentliche Schneidkante darstellt. Beim Trennvorgang wird diese durch das in das kreisförmige Innenloch in die Schnittposition gebrachte Werkstück geführt, bis eine Scheibe der gewünschten Dicke vollständig oder bis auf eine verbleibende Restverbindung, falls nach dem Verfahren gemäß der US-PS 45 13 544 gesägt wird, abgetrennt ist. Auf die Schneidkante wird dabei, in der Regel aus innerhalb des Innenloches angeordneten Zuleitungenein Kühlschmiermittel aufgebracht, welches zur Abführung der beim Sägen entstehenden Warme und auch zum Abtransport des abgetragenen Materials dient. Als derartige Kühlschmiermittel werden im allgemeinen Flüssigkeiten wie z.B. Wasser, dem ggf. Tenside wie z.B. Ethylenglykole, Organosilanole oder hochsulfatierte Fettsäuren zugesetzt sein können, oder Öle, beispielsweise auf Paraffinbasis, eingesetzt, welche zumeist in einem Vorratsgefäß bereitgestellt, über ein schlauchsystem an den Einsatzort gepumpt, und über Zuleitungen auf die Innen- und Seitenflächen der Schneidkante gelenkt werden.

Im IBM Technical Disclosure Bulletin Vol. 16, No. 8, S. 2550 vom Januar 1974 ist ein Beispiel für eine Düse durch die das Kühlschmiermittel zum Einsatzort gelangt, beschrieben.

Erfahrungsgemäß weicht bei jedem Sägevorgang wegen der im Sägespalt einwirkenden Kräfte das Sägeblatt von der angestrebten Schnittlinie ab, so daß die erhaltenen Scheiben stets eine i.a. unerwünschte Durchbiegung(in der Fachsprache oft als "bow" bzw. "warp" bezeichnet) aufweisen. Die Abweichung wird mit zunehmender Einsatzdauer immer stärker, bis schließlich die für die Durchbiegung der Scheiben vorgegebenen Toleranzen nicht mehr eingehalten werden können. In diesem Fall kann beispielsweise durch kurzzeitiges Sägen in ein hartes Material gemäß der DE-AS 23 59 096 oder durch Nachschärfen der Schneidkante die Schnittgenauigkeit wieder verbessert werden. Der Nachteil dieser Verfahrensweise liegt darin, daß die Abweichung des Sägeblattes von der angestrebten Schnittlinie erst anhand eines mangelhaften Produktes, d.h. unter Verlust wertvollen Materials, festgestellt werden kann. Zwar lassen sich mit Hilfe von geeigneten Entfernungsmeßvorrichtungen, wie z.B. Wirbelstrommeßgeräten, auch minimale Abweichungen des Sägeblattes bezüglich einer vorgegebenen Sollposition während des Sägevorganges erfassen. Allerdings kann auch in diesem Fall der Schnittverlauf nicht direkt beeinflußt werden, so daß die Verluste kaum vermindert werden. Überdies ist es bisweilen mehrmals hintereinander nötig, die Schneidkante nachzuschärfen und durch Kontrollschnitte zu überprüfen, bis sich erneut ein einwandfreier Schnittverlauf eingestellt hat. Dabei lassen sich die Sägeblätter nicht beliebig oft nachschärfen; Vielmehr verringert jeder Schärfvorgang ihre Lebensdauer und macht dadurch, neben den Zeitverlusten beim Nachschärfen, auch häufigen Wechsel der Sägeblätter erforderlich.

Im IBM Technical Disclosure Bulletin Vol. 25, No. 5, S. 2283-2284 vom 5. Oktober 1982 wird ein System beschrieben, welches das Aufziehen und die automatische Korrektur von Abweichungen des Sägeblattes von der gewünschten Schnittlinie gestattet. Das System besteht aus einem Detektor, der die Abweichung des Sägeblattes anzeigt und einer Vorrichtung, die nach Maßgabe des Detektorsignals eine die Abweichung kompensierende Flüssigkeit gegen die Schneidkante des Sägeblattes führt. Der Flüssigkeitsstrom wird dabei gegen die von der gewünschten Schnittlinie abweichende Sägeblattseite geführt.

Die Aufgabe der Erfindung lag darin, ein Verfahren anzugeben, das die genannten Nachteile vermeidat und das genaue Sägen von dünnen Scheiben innerhalb enger Durchbiegungstoleranz in hoher Ausbeute und bei verlängerten Sägeblattstandzeiten gestattet.

Die Aufgabe bestand ferner darin, eine Vorrichtung vorzuschlagen, mit der das erfindungsgemäße Verfahren durchgeführt werden kann.

Gelöst wird die Aufgabe durch ein Verfahren der eingangs genannten Art, welches dadurch gekennzeichnet ist, daß die durch ein seitliches Auswandern des Sägeblattes entstehende Abweichung des Sägeblattes von der gewünschten Schnittlinie dadurch korrigiert wird, daß eine größere flüssigkeitsmenge auf derjenigen Seitenfläche des Sägeblattes aufgebracht wird, auf der die gewünschte Schnittlinie liegt.

Die Aufgabe wird ferner durch eine Vorrichtung bestehend aus einer Innenlochsäge gelöst, bei welcher ein an seinem Außenumfang eingespanntes Sägeblatt mit seiner den Innenumfang bildenden, über Zuleitungen mit einem Kühlschmiermittel versorgten Schneidkante ein in das Innenloch eingeführtes, auf einem Zustelltisch befestigtes Werkstück durchtrennt, mit zumindest einem seitlich des Sägeblattes angeordneten, das Aufbringen einer Flüssigkeit auf zumindest eine der Seitenflächen des rotierenden Sägeblattes gestattendes Zuführorgan, die dadurch gekennzeichnet ist, daß das Zuführorgan das seitliche Auswandern des Sägeblattes von der gewünschten Schnittlinie durch das Aufbringen einer größeren Flüssigkeitsmenge auf derjenigen Seitenfläche des Sägeblattes, auf der sich die gewünschte Schnittlinie befindet, nahezu parallel zu den Seitenflächen und horizontal oder in einem von der Horizontalen um höchstens 30° abweichenden Winkel, zu korrigieren gestattet.

Unerwartet wurde nämlich gefunden, daß sich auf die erfindungsgemäße Weise die im Sägespalt auf das Sägeblatt wirkenden Kräfte und Druckverhältnisse gezielt beeinflußen lassen, so daß Abweichungen von der vorgegebenen oder angestrebten Schnittlinie auch während des Sägevorganges entgegengewirkt werden kann.

Als Flüssigkeiten können dabei solche Flüssigkeiten eingesetzt werden, die keine unzulässigen Verunreinigungen des Werkstückes, der Scheiben oder des Sägeblattes bewirken und sich gegenüber diesen unter den Bedingungen des Sägevorganges weitgehend inert verhalten. Im Falle der meisten Halbleiter- und Oxidmaterialien können daher als Flüssigkeiten insbesondere wässrige Systeme, beispielsweise reines Wasser oder Wasser, dem zur Vermeidung von Störungen durch Oberflächenspannungseffekte Tenside oder Emulgatoren, wie z.B. Ethylengykole, Organosilanole oder hochsulfatierte Fettsäuren zugesetzt sind, eingesetzt werden.

Grundsätzlich eignen sich auch Flüssigkeiten auf organischer Basis wie z.B. Paraffinöle oder Alkohole. Oftmals hat es sich bewährt, als Flüssigkeit die auch als Kühlschmiermittel verwendete Flüssigkeit einzusetzen, da sich dann die Möglichkeit ergibt, die beim Sägen anfallenden Flüssigkeitsmengen gemeinsam aufzufangen, ggf. beispielsweise durch Abtrennung des Sägeschlammes aufzubereiten und in einem Kreislauf erneut an den Einsatzort zurückzuführen.

Ein Teil der zusätzlich aufgebrachten Flüssigkeit wird von dem rotierenden Sägeblatt in den Sägespalt weitertransportiert und vermehrt die dort im seitlichen Zwischenraum zwischen Sägeblatt und Werkstück bzw. abzutrennender Scheibe vorhandene Flüssigkeitsmenge, die von dem über die Schneidkante In den Sägespalt transportierten Kühlschmiermittel herrührt. Dabei wird aufgrund der im Sägespalt sich einstellenden Druckverhältnisse das Sägeblatt jeweils in demjenigen Zwischenraum zu dessen Seitenwand hingezogen, in dem die größere Flüssigkeitsmenge vorhanden ist. Wird daher eine Abweichung des Sägeblattes von der gewünschten Schnittlinie festgestellt, so kann diesem Effekt entgegengewirkt werden, indem im Sägespalt die Druckunterschiede zwischen den Zwischenräumen links und rechts des Sägeblattes erhöht oder erniedrigt werden.

Methoden zur Erfassung des Schinittverlaufes und der Abweichung des Sägeblattes von einer vorgegebenen Sollschnittlinie sind bekannt. Beispielsweise kann zu diesem Zweck die Geometrie der abgetrennten Scheiben oder der Schnittfläche am Werkstück, insbesondere bezüglich der Durchbiegung, überprüft und beim jeweils nachfolgenden Sägevorgang entsprechend gegengesteuert werden. Vorteilhafter und im Rahmen des erfindungsgemäßen Verfahrens bevorzugt ist es jedoch, den Lauf des Sägeblattes während des Sägevorganges periodisch oder insbesondere permanent zu kontrollieren. Dafür eignen sich beispielsweise Wirbelstrommeßgeräte, wie sie zur Entfernungsmessung bei bewegten, ebenen Metalloberflächen üblicherweise häufig eingesetzt werden. Gleichfalls denkbar ist der Einsatz von Entfernungsmessern auf Laserbasis oder Infrarotsensoren.

Bedingt durch die rasche Rotation des Sägeblattes während des Sägevorganges (Drehgeschwindigkeit typisch ca. 600 bis 4000 UPM) wirken starke radikale Kräfte auf die auf die Seitenflächen aufgebrachte Flüssigkeit, so daß die Gefahr besteht, daß sie nach außen geschleudert wird, ehe sie im Sägespalt wirksam werden kann. Aus diesem Grund hat es sich als zweckmäßig erwiesen, die jeweils ausgewählte Flüssigkeit horizontal oder in einem von der Horizontalen um höchstens 30° abweichenden Winkel auf die Seitenflächen des Sägeblattes mittels Düsen aufzubringen und zwar möglichst parallel oder nahezu parallel zu den Seitenflächen des Sägeblattes, so daß die Flüssigkeit erst im Bereich kurz vor dem Sägespalt streifend mit diesen in Kontakt kommt. Neben der grundsätzlich möglichen Verwendung von Düsen mit spaltförmigem oder eckigem Querschnitt werden vorzugsweise Düsen mit rundem Querschnitt eingesetzt, wobei in der Regel Öffnungen mit einem Durchmesser, der dem 1 bis 50-fachen des Abstandes zwischen der Seitenfläche des Sägeblattes und dem Werkstück im Sägespalt (zumeist etwa 0,1 bis 1,5 mm) entspricht, vorgesehen werden.

Die optimale Strahlrichtung, Position und Anzahl der Düsen hängt im wesentlichen von den Maßen des Werkstückes ab. Während beispielsweise bei Durchmessern bis zu etwa 8 cm in der Regel auch mit einer Düse gut Schnittergebnisse zu erzielen sind, ist bei größeren Werkstücken zumeist der Einsatz von mehreren Düsen erforderlich, um eine für die Beeinflussung des Sägeblattes ausreichende Flüssigkeitsmenge in den Sägespalt einbringen zu können. Zweckmäßig wird anhand von Vorversuchen ermittelt, mit welcher Düsenanzahl, aus welcher Position und mit welcher Strahlrichtung eine zuverlässige Steuerung des Schnittverlaufs möglich ist.

Vorteilhaft werden die Düsen zu beiden Seiten des Sägeblattes symmetrisch angeordnet, obwohl eine solche Anordnung nicht zwingend vorgeschrieben ist. Beispielsweise aus Platzgründen kann auch, insbesondere im Fall von Mehrblattinnenlochsägen, eine asymmetrische Anordnung der Düsen gewählt werden. Als Grenzfall ist es sogar möglich, eine oder mehrere Düsen lediglich auf einer Seite des Sägeblattes anzubringen und den Schnittverlauf dadurch zu steuern, daß bei bezüglich der Düsen sich wegbewegenden Sägeblatt eine Flüssigkeit auf die Seitenfläche aufgebracht wird.

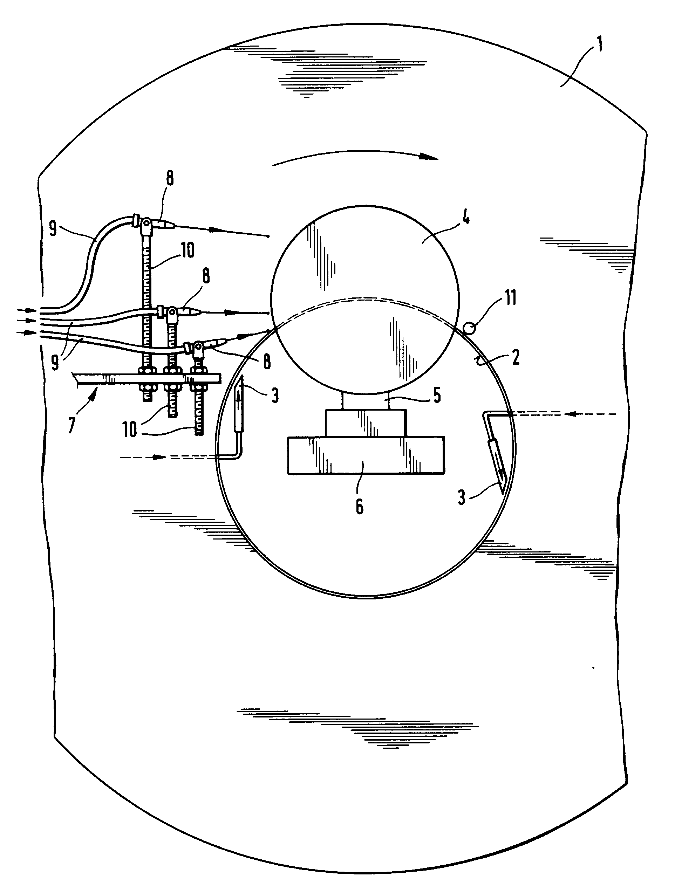

Das erfindungsgemäße Verfahren und eine zu seiner Durchführung geeignete Vorrichtung werden anhand der Figur näher erläutert.

Dabei ist schematisch im Querschnitt der Innenlochbereich einer herkömmlichen Innenlochsäge dargestellt, die zusätzlich mit einem System von Düsen ausgerüstet ist, um den Sägevorgang in der erfindungsgemäßen Art und Weise durchzuführen.

Das nur ausschnittweise gezeigte rotierende Sägeblatt 1, welches in der üblichen Weise in einen aus Gründen der Übersichtlichkeit nicht dargestellten Spannrahmen eingespannt ist, besitzt an seinem Innenumfang eine beispielsweise aus in Nickel eingebetteten Diamantkörnern bestehende Schneidkante 2. Diese wird über die beiden Zuleitungen 3 kontinuierlich mit einem Kühlschmiermittel, beispielsweise tensidhaltigem Wasser, versorgt.

Beim Sägevorgang arbeitet sich die Schneidkante 2 durch das Werkstück 4, beispielsweise einen Siliciumstab, der in bekannter Weise z.B. mittels einer aufgeklebten Kohleleiste 5 mit dem Zustelltisch 6 verbunden ist. Das beim Sägen abgetragene Material wird zusammen mit dem vom Sägeblatt mitgeführten Kühlschmiermittel aus dem Sägespalt ausgetragen.

Zusätzlich zu diesen bei Innenlochsägen bekannten und üblichen Elementen ist bei der vorliegenden Anordnung ein Düsensystem 7 vorgesehen, das es ermöglicht, auf die Seitenfläche des Sägeblattes 1 eine Flüssigkeit aufzubringen. Dabei sind die einzelnen Düsen 8, welche beispielsweise in ihrer Position verstellbar sein können, über Schläuche 9 mit einem Flüssigkeitsreservoir verbunden. Aus diesem kann die ausgewählte Flüssigkeit, beispielsweise reines oder tensidhaltiges Wasser, z.B. mittels Pumpen oder pneumatischem Druck, über das Schlauchsystem zu den Düsen 8 gefördert werden. Vorteilhaft sind den Düsen 8 jeweils Durchflußregulantien, beispielsweise Ventile, vorgeschaltet, welche die Unterbrechung und günstig auch die Dosierung des Flüssigkeitsstroms gestatten.

Zweckmäßig sind die Düsen 8 mit Halterungen 10 versehen, welche möglichst vielseitige Einstellmöglichkeiten bieten, durch welche ihre Position und die Richtung der von ihnen ausgehenden Flüssigkeitsstrahlen an wechselnde Werkstückgrößen angepaßt werden können. In einer Weiterbildung des Erfindungsgedankens ist vorgesehen, die Anordnung und Orientierung der Düsen auch während des Sägevorganges regel- und einstellbar zu gestalten. Gemäß einer bevorzugten Ausführungsform der Erfindung ist auf der anderen Seite des Sägeblattes dasselbe Düsensystem spiegelbildlich vorgesehen.

Die Düsen 8 sind günstig so eingestellt, daß der von ihnen ausgehende Strahl nahezu parallel zum Sägeblatt verläuft und streifend auf dessen Seitenfläche auftrifft. Die Höheneinstellung der Düsen 8 wird zweckmäßig anhand von Vorversuchen ermittelt; allgemein ist es jedoch vorteilhaft, die Hauptmenge der Flüssigkeit in einem sich an die Schneidkante anschließenden, ca. 0,5 bis 5 cm breiten Bereich aufzubringen.

In manchen Fällen, insbesondere bei Werkstückdurchmessern bis zu etwa 10 cm, kann auf das zusätzliche Aufbringen von Flüssigkeit außerhalb dieses Bereiches verzichtet werden, so daß eine dementsprechend geringere Zahl von Düsen eingesetzt werden kann.

Die axiale Auslenkung des Sägeblattes läßt sich beispielsweise mittels eines Wirbelstrommeßgerätes 11 überwachen, welches Abweichungen von der Sollposition registrieren und beispielsweise mittels einer Anzeigetafel oder einem Schreiber erfassen kann.

Der eigentliche Sägevorgang wird in der Regel begonnen, ohne daß auf die Seitenflächen des Sägeblattes eine Flüssigkeit aufgebracht wird. Zeigt das Meßgerät jedoch mit fortschreitendem Vordringen in das Werkstück (eine die zulässige Toleranzgrenze überschreitende Abweichung des Sägeblattes aus der Sollposition, wird zumindest eines der zunächst in Sperrstellung gehaltenen Dosierventile,und zwar in der Regel zuerst das auf die unterste Düse wirkende, geöffnet. Die nun auf das Sägeblatt aufgebrachte Flüssigkeit wird von diesem mitgerissen, dringt zumindest teilweise in den Sägespalt ein und bewirkt dort eine Veränderung der auf das Sägeblatt einwirkenden Kräfte. Das Sägeblatt wird durch das Aufbringen einer Flüssigkeit über das linke Düsensystem nach links, über das rechte Düsensystem nach rechts gezogen. Auf diese Weise kann der Abweichung des Sägeblattes von der angestrebten Schnittlinie während des Sägens entgegengewirkt werden, wobei der Vorgang kontinuierlich verfolgt wird, beispielsweise mittels des Wirbelstommeßgerätes.

Wenn das Sägeblatt wieder in die erwünschte Position zurückgewandert ist, wird der eingestellte Volumenstrom der Flüssigkeit beibehalten, bis eine neuerliche Abweichung von der angestrebten Schnittlinie festgestellt wird. Bei Abweichung in die Gegenrichtung kann in entsprechender Weise dann mit den in symmetrischer Position auf der anderen Sägeblattseite befindlichen Düsen reagiert werden, wobei grundsätzlich ein gleichzeitiges Einwirken beider Düsensysteme nicht ausgeschlossen ist.

Während es zu Beginn des Sägevorganges, d.h. bei geringer Eindringtiefe der Schneidkante in das Werkstück (ebenso wie in vielen Fällen bei Werkstückdurchmessern bis zu etwa 8 cm) ausreicht, die Flüssigkeit lediglich vermittels einer Düse pro Sägeblattseite aufzubringen, werden bei größeren Werkstücken insbesondere gegen Ende des Schnittes in der Regel zwei oder mehrere Düsen benötigt. Dabei lassen sich über die verschiedenen Düsen auch verschiedene Flüssigkeiten zur Anwendung bringen.

Die Regulierung der erforderlichen Volumenströme kann nach Maßgabe des Schnittverlaufes über die Dosierventile von Hand erfolgen. In einer Weiterbildung des Erfindungsgedankens können zur Steuerung automatisch regelbare, z.B. motorgetriebene Ventile vorgesehen werden, so daß das Verfahren beispielsweise durch den Einsatz einer Rechnersteuerung, die jeweils die Istposition des Sägeblattes mit der Sollposition vergleicht und dementsprechend die Volumenströme reguliert, weitgehend automatisiert werden kann.

In den Fällen, in denen sich die Schnitteigenschaften des Sägeblattes bereits soweit verschlechtert haben, daß es sich auch vermittels des erfindungsgemäßen Verfahrens nicht mehr in der vorgesehenen Schnittlinie halten läßt, kann die Schneidkante in der bekannten Art und Weise nachgeschärft werden, wonach in der Regel - außer bei bereits zu stark abgetragener Schneidkante - wieder durch zumindest zeitweises Aufbringen einer Flüssigkeit auf die Seitenflächen ein einwandfreier Schnittverlauf sichergestellt werden kann.

Das erfindungsgemäße Verfahren und die erfindungsgemäße Vorrichtung ermöglichen es, Kristallstäbe oder -blöcke, insbesondere aus Halbleiter- oder oxidischen Materialien mit gegenüber den üblichen Methoden erhöhter Präzision in dünne Scheiben zu zersägen. Dabei ist es nicht nur möglich, die Durchbiegung der Scheiben (bow bzw. warp) innerhalb enger Toleranzgrenzen zu halten, sondern auch Scheiben einer bestimmten, definierten Durchbiegung zu sägen. Da das Verfahren weiterhin auch erheblich weniger Schärfeingriffe erforderlich macht, kann die Sägeblattstandzeit deutlich erhöht werden. Überdies können herkömmliche Innenlochsägen, unabhängig vom Sägeblattdurchmesser, problemlos auch nachträglich entsprechend umgerüstet werden.

Dies gilt sowohl für Anordnungen mit vertikal oder horizontal rotierendem Sägeblatt oder solche, bei denen auch das Werkstück eine Rotation oder Oszillation während des Sägens ausführt.

Nachstehend wird das erfindungsgemäße Verfahren beispielhaft näher erläutert:

### Beispiel 1:

Eine herkömmliche Innenlochsäge (Sägeblattdurchmesser ca. 680 mm, Innenlochdurchmesser ca. 235 mm) mit in einem Spannrahmen am Außenumfang eingespannten Sägeblatt mit diamantbesetztem Innenumfang, auf den mittels zweier gemäß der Figur angeordneter Zuleitungen während des Betriebes ein ständiger Strom eines Kühlschmiermittels (Netzmittel-Wasser-Mischung) aufgebracht werden konnte, war zusätzlich mit einem relativ zum Sägeblatt ortsfesten, zu dessen beiden Seiten symmetrischen gemäß Figur gestalteten Dreier-Düsensystem ausgerüstet.

Die in Vorversuchen ermittelte Einstellung der in ihrer Halterung höhen- und seitenverstellbaren Rundstrahldüsen (Strahldurchmesser ca. 1 mm) war derart gewählt, daß die Bereiche, in denen die Strahlen streifend auf die Seitenflächen des Sägeblattes auftrafen, radial in etwa einen dem Werkstückradius entsprechenden Abstand voneinander hatten. Dabei kam, von der Schneidkante aus gerechnet, der unterste Strahl in einer Entfernung von etwa 0,1 cm, der mittlere bei etwa 1,5 cm und der äußerste in etwa 7 cm Entfernung in Kontakt mit dem Sägeblatt. Daneben war der Auftreffpunkt so gewählt, daß die geringste Entfernung zum Außenumfang des Werkstückes im Verlauf des Sägevorganges in etwa 0,1 cm betrug. Die hier genannten Einstellmöglichkeiten sind selbstverständlich nur beispielhaft und nicht im Sinne einer Beschränkung zu verstehen.

Über ein Schlauchsystem waren die Düsen mit einem Regelungssystem (handgeregeltes Dosierventil mit Durchflußmessern) verbunden, mit dessen Hilfe jede einzelne Düse bei Bedarf mit einem in seiner Stärke regelbaren Volumenstrom versorgt werden konnte. Als Flüssigkeit wurde Wasser eingesetzt, das in einem Reservoir bereitgestellt und über Schläuche mit einem Druck von ca. 3 bar mit dem Regelungssystem verbunden war.

In etwa 5 mm Abstand zu einer Seitenfläche war im Austrittsbereich der Schneidkante aus dem Werkstück ein Wirbelstrommeßgerät ortsfest angebracht, vermittels dessen über eine Anzeigetafel die Abweichung des Sägeblattes aus einer vorgegebenen Sollposition während des Sägevorganges auf etwa 0,5 µm genau verfolgt werden konnte.

Der Sägevorgang, bei dem ein einkristalliner Siliciumstab mit ca. 150 mm Durchmesser in geometrisch einwandfreie Scheiben von ca. 600 µm Dicke zersägt werden sollte, wurde zunächst in der üblichen Weise begonnen, indem das Werkstück mit Hilfe des Zustelltisches in die gewünschte Schnittposition gefahren wurde. Durch eine vertikale Relativbewegung wurde nun die Schneidkante des rotierenden Sägeblattes in Kontakt mit dem Siliciumstab gebracht und begann, unter dauernder Zufuhr von Kühlschmiermittel, in das Werkstück einzudringen.

Die Auslenkung des Sägeblattes wurde während des fortschreitenden Sägevorganges mit Hilfe des Wirbelstrommeßgerätes genau überwacht; als Toleranzgrenze war willkürlich eine Abweichung von ± 15 µm aus der Ausgangsposition als noch Zulässig vorgegeben worden. (Die Toleranzgrenze kann grundsätzlich auch enger oder weiter gesetzt werden und richtet sich in der Regel nach den Vorgaben der Bauelementehersteller). Zeigte das Meßgerät an, daß das Sägeblatt um mehr als 2 µm in eine bestimmte Richtung abzuweichen begann, wurde auf der jeweils gegenüberliegenden Seite zunächst über die unterste Düse ein Wasserstrahl auf die Seitenfläche des Sägeblattes geschickt und über das Dosierventil soweit verstärkt, bis das Sägeblatt wieder zurückzuwandern begann. Bei Annäherung an die Sollposition wurde die Einstellung des Dosierventils bis zu einer erneuten Abweichung beibehalten. Bei einer Abweichung in die Gegenrichtung wurde der Volumenstrom zunächst reduziert und bei Bedarf von der anderen Seite aus entsprechend gegengesteuert. Ab einer Schnittiefe von ca. 75 mm mußte zusätzlich die zweite und ab ca. 100 mm auch die dritte Düse herangezogen werden, um das Sägeblatt innerhalb der vorgegebenen Toleranzgrenzen halten zu können.

In den Fällen, in denen das Sägeblatt im Verlauf des Sägevorganges trotz der Gegenregelung nicht mehr innerhalb der Toleranzgrenze (± 15 µm) gehalten werden konnte, wurde die Schneidkante in der bekannten Art nach Beendigung des Schnittes nachgeschärft. Solche Schärfeingriffe waren jeweils nach etwa 40 bis 60 Sägevorgängen erforderlich.

Am Ende des Schnittes wurde jede abgetrennte Scheibe mittels eines Scheibenabnehmers entnommen und gereinigt. Die Scheibenoberfläche wurde schließlich in einem handelsüblichen Kontrollgerät mit Hilfe einer berührungslos wirkenden kapazitiven Meßmethode auf ihre Durchbiegung (bow bzw. warp) untersucht.

Zur Ermittlung der Sägeblattstandzeit wurde nach derselben Methode solange gesägt, bis auch durch Nachschärfen ein einwandfreier und steuerbarer Lauf mit reproduzierbaren Schnittresultaten des Sägeblattes nicht mehr zu gewährleisten war. Diese Standzeit wurde als Vergleichswert registriert.

### Vergleichsbeispiel:

Mit einem neuen Sägeblatt wurde in derselben Anordnung unter denselben Bedingungen eine weitere Schnittserie an einkristallinen Siliciumstäben mit 150 mm Durchmesser durchgeführt. Der Unterschied bestand darin, daß während des Sägevorganges keine Flüssigkeit aus den Düsen auf die Seitenflächen des Sägeblattes aufgebracht wurde. Bei Abweichungen um mehr als ± 15 µm von der Sollschnittlinie wurde nach der konventionellen Methode die Schneidkante nachgeschärft. Dieser Vorgang mußte nach jeweils 10 bis 15 Sägevorgängen wiederholt werden.

Die Standzeit dieses Sägeblattes, d.h. die Betriebszeit, innerhalb welcher ein einwandfreier Lauf und reproduzierbare Schnittergebnisse zu erzielen waren, betrug aufgrund der erheblich häufiger erforderlichen Schärfeingriffe nur ca. 60 % des durch das erfindungsgemäße Verfahren gesetzten Standardwertes.

Die Geometrie der erhaltenen Scheiben wurde ebenfalls mit Hilfe der genannten kapazitiven Meßmethode kontrolliert.

## Patentansprüche

1. Verfahren zur Korrektur der Abweichung eines Sägeblattes (1) von der gewünschten Schnittlinie beim Zersägen von Kristallstäben oder -blöcken in dünne Scheiben vermittels Innenlochsäge, wobei während des Sägevorganges ein flüssiges Kühlschmiermittel auf die Schneidkante (2) des Sägeblattes (1) aufgebracht wird und zusätzlich eine Flüssigkeit außerhalb des Sägespaltes auf eine oder beide Seitenflächen des rotierenden Sägeblattes (1) aufgebracht und durch die Rotation des Sägeblattes (1) zumindest teilweise in den Sägespalt transportiert wird, dadurch gekennzeichnet, daß die durch ein seitliches Auswandern des Sägeblattes (1) entstehende Abweichung des Sägeblattes (1) von der gewünschten Schnittlinie dadurch korrigiert wird, daß eine größere Flüssigkeitsmenge auf derjenigen Seitenfläche des Sägeblattes (1) aufgebracht wird, auf der die gewünschte Schnittlinie liegt.

2. Verfahren nach Anspruch 1, dadurch gekennzeichnet, daß die Flüssigkeit vermittels beiderseits des Sägeblattes (1) symmetrisch angeordneter Düsen (8) auf die Seitenflächen aufgebracht wird.

3. Verfahren nach den Ansprüchen 1 und 2, dadurch gekennzeichnet, daß die Flüssigkeit bezüglich des Sägeblattes (1) nahezu parallel zu dessen Seitenflächen auf diese aufgebracht wird.

4. Verfahren nach einem oder mehreren der Ansprüche 1 bis 3, dadurch gekennzeichnet, daß die Flüssigkeit horizontal oder in einem von der Horizontalen um höchstens 30° abweichenden Winkel auf die Seitenflächen aufgebracht wird.

5. Verfahren nach einem oder mehreren der Ansprüche 1 bis 4, dadurch gekennzeichnet, daß als Flüssigkeit wässerige Systeme eingesetzt werden.

6. Innenlochsäge zur Durchführung des Verfahrens nach einem oder mehreren der Ansprüche 1 bis 5, bei welcher ein an seinem Außenumfang eingespanntes Sägeblatt (1) mit seiner den Innenumfang bildenden, über Zuleitungen (3) mit einem Kühlschmiermittel versorgten Schneidkante (2) ein in das Innenloch eingeführtes, auf einem Zustelltisch (6) befestigtes Werkstück (4) durchtrennt, mit zumindest einem seitlich des Sägeblattes (1) angeordneten, das Aufbringen einer Flüssigkeit auf zumindest eine der Seitenflächen des rotierenden Sägeblattes (1) gestattendes Zuführorgan (7), dadurch gekennzeichnet, daß das Zuführorgan (7) das seitliche Auswandern des Sägeblattes (1) von der gewünschten Schnittlinie durch das Aufbringen einer größeren Flüssigkeitsmenge auf derjenigen Seitenfläche des Sägeblattes (1), auf der sich die gewünschte Schnittlinie befindet, nahezu parallel zu den Seitenflächen und horizontal oder in einem von der Horizontalen um höchstens 30° abweichenden Winkel, zu korrigieren gestattet.

7. Innenlochsäge nach Anspruch 6, gekennzeichnet durch zwei symmetrisch beiderseits des Sägeblattes angeordnete mit Dosiereinrichtungen und Flüssigkeitsreservoir verbundene Düsensysteme als Zuführorgan.

## Claims

1. Process for correcting the deviation of a saw blade (1) from the desired cutting line when sawing crystal rods or blocks into thin wafers by means of an internal cutting wheel, a liquid cooling lubricant being applied to the cutting edge (2) of the saw blade (1) during the sawing operation and, in addition, a liquid being applied outside the sawing gap to one or both side surfaces of the rotating saw blade (1) and transported by the rotation of the saw blade (1) at least partially into the sawing gap, characterized in that the deviation of the saw blade (1) from the desired cutting line caused by a lateral shifting of the saw blade (1) is corrected by a greater amount of liquid being applied to that side surface of the saw blade (1) on which the desired cutting line lies.

2. Process according to Claim 1, characterized in that the liquid is applied to the side surfaces by means of nozzles (8) arranged symmetrically on either side of the saw blade (1).

3. Process according to Claim 1 or Claim 2, characterized in that the liquid is applied to the side surfaces virtually parallel to the same with respect to the saw blade (1).

4. Process according to one or more of Claims 1 to 3, characterized in that the liquid is applied to the side surfaces horizontally or at an angle deviating from the horizontal by 30° at the most.

5. Process according to one or more of Claims 1 to 4, characterized in that aqueous systems are used as liquid.

6. Internal cutting wheel for implementation of the process according to one or more of Claims 1 to 5, in which a saw blade (1), clamped at its outer periphery, severs a workpiece (4), which is fixed on an infeed table (6) and is introduced into the inner hole, by its cutting edge (2), which forms the inner circumference and is supplied with a cooling lubricant via supply lines (3), having at least one supply element (7) which is arranged to the side of the saw blade (1) and allows the application of a liquid to at least one of the side surfaces of the rotating saw blade (1), characterized in that the supply element (7) allows the lateral shifting of the saw blade (1) from the desired cutting line to correct [sic] by the applying of a greater amount of liquid on that side surface of the saw blade (1) on which the desired cutting line is located, virtually parallel to the side surfaces and horizontally or at an angle deviating from the horizontal by 30° at the most.

7. Internal cutting wheel according to Claim 6, characterized by two nozzle systems, as supply elements, arranged symmetrically on either side of the saw blade and connected to metering devices and a liquid reservoir.

## Revendications

1. Procédé de correction de la déviation d'une lame de scie (1) à partir de la ligne de coupe désirée, lors du sciage de tiges ou de blocs de cristal en disques minces par l'intermédiaire d'une scie à alésage intérieur, dans lequel pendant le processus de sciage un moyen liquide de réfrigération et de lubrification est rapporté sur la surface (2) de coupe de la lame (1) de scie, et en outre un liquide est rapporté extérieurement au trait de soie sur l'une ou deux des surfaces latérales de la lame (1) de soie tournante, et est transporté par l'intermédiaire de la rotation de la lame (1) de scie au moins partiellement dans le trait de scie, caractérisé en ce que la déviation de la lame (1) de scie à partir de la ligne de coupe désirée, correspondant à une dérive latérale de la lame (1) de scie, est corrigée par le fait qu'une plus grande quantité de liquide est rapportée sur la surface latérale de la lame (1) de soie sur laquelle se trouve la ligne de coupe désirée.

2. Procédé selon la revendication 1, caractérisé en ce que le liquide est rapporté sur les surfaces latérales au moyen de buses (8) disposées symétriquement des deux côtés de la lame (1) de soie.

3. Procédé selon les revendications 1 et 2, caractérisé en ce que le liquide est rapporté sur les surfaces latérales quasiment parallèlement à ces dernières par rapport à la lame (1) de soie.

4. Procédé selon l'une au moins des revendications 1 à 3, caractérisé en ce que le liquide est rapporté sur les surfaces latérales de manière horizontale ou selon un angle de déviation d'au plus 30° par rapport à l'horizontale.

5. Procédé selon au moins une des revendications 1 à 4, caractérisé en ce que l'on utilise comme liquide un système aqueux.

6. Scie à alésage intérieur pour la réalisation du procédé selon l'une au moins des revendications 1 à 5, comprenant une lame (1) de soie fixée sur son périmètre extérieur et formant avec le sien le périmètre intérieur, dont la surface (2) de coupe est alimentée en réfrigérant et lubrifiant au moyen de conduites (3), et permettant la séparation de pièces (4) de travail immobilisées sur une table (6) de positionnement et conduite dans l'alésage intérieur, comprenant au moins un organe (7) d'alimentation disposé latéralement à la lame (1) de scie et permettant l'alimentation d'un liquide sur au moins une des surfaces latérales de la lame (1) tournante de scie, caractérisée en ce que l'organe (7) d'alimentation permet de corriger la dérive latérale de la lame (1) de soie à partir de la ligne de coupe désirée, par l'intermédiaire d'un apport d'une quantité de liquide plus importante sur la surface latérale de la lame (1) de soie sur laquelle la ligne de coupe désirée se trouve, presque parallèlement aux surface latérales et horizontalement ou selon un angle de déviation d'au plus 30° par rapport à l'horizontale.

7. Scie à alésage intérieur selon la revendication 6, caractérisée par l'utilisation de deux systèmes de buses en tant qu'organes d'alimentation, disposées symétriquement des deux côtés de la lame de scie et reliées avec un équipement de dosage et un réservoir de liquide.
